# EUROPEAN PATENT SPECIFICATION

(11) **EP 2 249 379 B1**
(45) Date of publication and mention of the grant of the patent: **11.07.2012**
(21) Application number: 09710337.8
(22) Date of filing: 10.02.2009
(51) Int. Cl.: H01L 21/205, C23C 16/455

(54) **BATCH-TYPE ATOMIC LAYER VAPOUR-DEPOSITION DEVICE**
ATOMSCHICHT-AUFDAMPFEINRICHTUNG DES BATCH-TYPS
DISPOSITIF DE MÉTALLISATION SOUS VIDE DE COUCHE ATOMIQUE PAR LOTS

(30) Priority: 12.02.2008 KR 20080012458
(43) Date of publication of application: 10.11.2010
(73) Proprietor: Choi, Kyu-Jeong, Daejeon 305-744 (KR)
(72) Inventor: Choi, Kyu-Jeong, Daejeon 305-744 (KR)
(74) Representative: Chaillot, Geneviève
(86) International application number: PCT/KR2009/000607
(87) International publication number: WO 2009/102133

(56) References cited:
- EP-A2- 1 674 592
- JP-A- 2002 222 806
- JP-A- 2004 162 114
- JP-A- 2007 217 762
- US-A1- 2005 287 806
- US-A1- 2006 156 979
- US-A1- 2006 281 337

## Description

### CROSS-REFERENCE TO RELATED PATENT APPLICATION

This application claims the benefit of Korean Patent Application No. 10-2008-0012458, filed on February 12, 2008, in the Korean Intellectual Property Office, the disclosure of which is incorporated herein by reference.

### BACKGROUND OF THE INVENTION

### 1. Field of the Invention

The present invention relates to a batch-type Atomic Layer Deposition (ALD) apparatus for performing ALD processing collectively for a plurality of substrates, and more particularly, to a batch-type ALD apparatus for performing ALD processing collectively for a plurality of substrates, leading to an improved throughput, and achieving perfect uniformity of ALD on the substrates.

### 2. Description of the Related Art

Generally, semiconductor devices, flat panel displays, etc. are manufactured through various processes, among which a process of depositing a thin film on a substrate, such as a wafer or a glass, is essential. Such thin film deposition is achieved mainly by sputtering, Chemical Vapor Deposition (CVD), Atomic Layer Deposition (ALD), or the like.

With respect to sputtering, a high voltage is applied to a target in a vacuum chamber, and an inert gas, such as argon, is introduced into the vacuum chamber to produce argon ions in a plasma state. At this time, the argon ions collide with a surface of the target, and atomic species of a target material are ejected from the surface of the target and deposited on a substrate.

The sputtering can be used to form a high-purity thin film having a good adhesion with a substrate, but is not suitable for fine patterning because, in case of forming a large-scale integration (LSI) film having a processing difference, it is very difficult to achieve film uniformity.

CVD, which is a widely used deposition technique for the preparation of thin films, is a process of forming a thin film to a desired thickness on a substrate using reactive gases and carrier gases. In the CVD process, for example, various gases are introduced into a reaction chamber and activated by high energy, such as heat, light, or plasma, to deposit a thin film to a desired thickness on a substrate through a chemical reaction between the gases.

In the CVD process, a deposition rate can be controlled by adjusting reaction conditions such as the amount of plasma used as a reaction energy source, and the ratio and amounts of reactive gases.

However, the CVD process may have severe difficulty in controlling the thermodynamic stability of atoms and undesirably deteriorate the physical, chemical or electrical characteristics of a thin film due to rapid reactions occurring among reactive gases.

ALD is a process of depositing a thin film as an atomic layer unit by alternately supplying a source gas (reactive gas) and a purge gas. A thin film formed by ALD has a high aspect ratio, a uniform structure even at low pressure conditions, and good electrical/physical characteristics.

Such an ALD process based on surface reactions has been recently proposed as an alternative to CVD that offers poor step coverage for very high aspect ratio structures.

An ALD apparatus can be classified into a batch-type apparatus for performing ALD processing collectively for a plurality of substrates and a single substrate-type apparatus for performing ALD processing one by one for a plurality of substrates.

Conventionally, a single substrate-type ALD apparatus has a low throughput due to one-by-one ALD processing. On the other hand, a batch-type ALD apparatus has problems such as low deposition efficiency and poor film quality since ALD processing is performed collectively for a plurality of substrates stacked in a chamber.

Therefore, it is necessary to develop an ALD apparatus that can achieve a high throughput, good film quality, and high deposition efficiency.

### SUMMARY OF THE INVENTION

The present invention provides a batch-type Atomic Layer Deposition (ALD) apparatus achieving a high throughput due to batch processing, and enabling each separate and uniform ALD processing for a plurality of substrates, thus ensuring improved deposition efficiency and film quality.

According to the present invention, there is provided a batch-type ALD apparatus including: a chamber that can be kept in a vacuum state; a substrate support member, disposed in the chamber, supporting a plurality of substrates to be stacked one onto another with a predetermined pitch; a substrate movement device moving the substrate support member upward or downward; a gas spray device continuously spraying a gas in a direction parallel to the extending direction of each of the substrates stacked in the substrate support member; and a gas discharge device, disposed in an opposite side of the chamber to the gas spray device, sucking and evacuating the gas sprayed from the gas spray device.

The substrate movement device moves the substrate support member periodically in such a way that the substrate support member is moved by a pitch between vertically adjacent ones of the substrates and then stopped for a predetermined time, thus guaranteeing continuous gas spraying and improved ALD accuracy.

The gas spray device includes one or more gas spray blocks, each of which includes a plurality of gas spray layers operated independently with respect to each other, thus enabling an optional modification of ALD process conditions.

Each gas spray block has a sequential vertical array of a first purge gas spray layer, a first reactive gas spray layer, a second purge gas spray layer, a second reactive gas spray layer, and a third purge gas spray layer.

The first, second, and third purge gas spray layers may each be multi-layered in order to more efficiently isolate the first and second reactive gas spray layers from each other.

The gas discharge device may include a single outlet disposed to correspond to all the gas spray layers of the gas spray device.

Alternatively, the gas discharge device may also include one or more outlet layers, disposed to correspond to the one or more gas spray blocks, being operated independently with respect to each other.

Still alternatively, the gas discharge device may also include a plurality of outlet layers, disposed to correspond to a plurality of gas spray units that each consists of a purge gas spray layer, a reactive gas spray layer, and a purge gas spray layer, being operated independently with respect to each other.

Still alternatively, the gas discharge device may also include a plurality of outlet layers, disposed to correspond to the plurality of the gas spray layers, being operated independently with respect to each other.

The gas spray device may have a convexly curved cross-sectional shape at least partially surrounding the substrate support member in order to guarantee good film uniformity for the substrates.

The gas discharge device may also have a convexly curved cross-sectional shape at least partially surrounding the substrate support member.

The substrate support member may include a heating device heating the substrates in order to easily change process conditions

The substrate support member may include a plurality of buffer layers having no substrate thereon, which are disposed at top and bottom sides of the substrate support member.

The substrate support member may include a substrate rotation device rotating the substrates disposed thereon in order to guarantee film uniformity.

The batch-type ALD apparatus may further include a blocking plate, interposed between a lateral side of the gas spray device and the opposite lateral side of the gas discharge device, surrounding the substrate support member together with the gas spray device and the gas discharge device to prevent the diffusion of reactive gases toward other spaces of the chamber, thus ensuring better film quality.

The batch-type ALD apparatus may further include a protection cover disposed at top sides of the gas spray device and the gas discharge device and insertedly mounted to the substrate support member to protect the substrates.

The batch-type ALD apparatus may further include an auxiliary gas discharge device disposed at the chamber to suck and evacuate gases in the chamber.

### BRIEF DESCRIPTION OF THE DRAWINGS

The above and other features and advantages of the present invention will become more apparent by describing in detail exemplary embodiments thereof with reference to the attached drawings in which:
FIG. 1 is a sectional view illustrating a batch-type Atomic Layer Deposition (ALD) apparatus according to an exemplary embodiment of the present invention;
FIG. 2 is a partially enlarged sectional view illustrating a gas spray device and a gas discharge device according to an exemplary embodiment of the present invention;
FIG. 3 is a top view illustrating the positioned state of a gas spray device, a gas discharge device, and a substrate support member according to an exemplary embodiment of the present invention; and
FIGS. 4 and 5 are views illustrating gas spray devices according to some embodiments of the present invention

### DETAILED DESCRIPTION OF THE INVENTION

The present invention will now be described more fully with reference to the accompanying drawings, in which exemplary embodiments of the invention are shown.

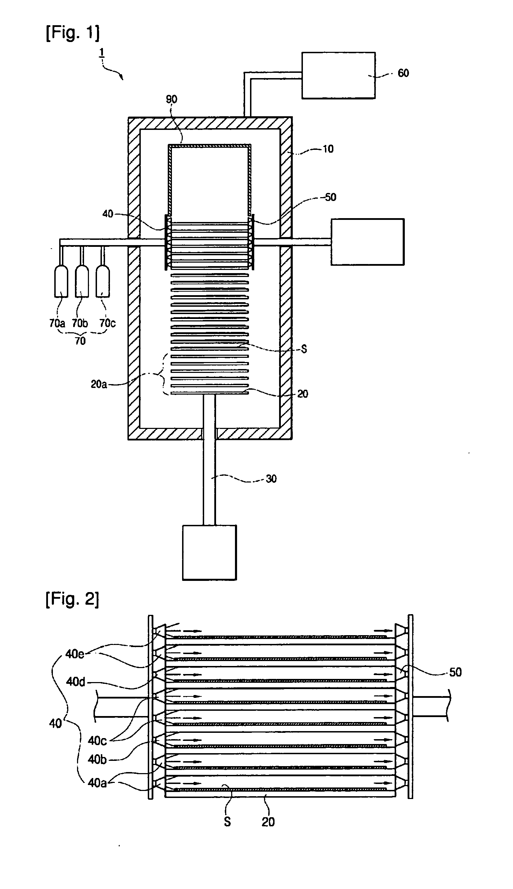

Referring to FIG. 1 illustrating a batch-type Atomic Layer Deposition (ALD) apparatus 1 according to an exemplary embodiment of the present invention, the ALD apparatus 1 includes a chamber 10, a substrate support member 20, a substrate movement device 30, a gas spray device 40, and a gas discharge device 50.

The chamber 10 has an internal space and may be structured such that the internal space is kept in a vacuum state. Thus, the chamber 10 includes a high vacuum pump 60 for evacuating a gas in the chamber 10. Further, the chamber 10 may also include a venting device (not shown) for injecting a gas into the chamber 10. The chamber 10 may also include a temperature adjuster (not shown) for adjusting the internal temperature of the chamber 10.

The chamber 10 may have a gate (not shown) for receiving or releasing the substrate support member 20 having a vertically stacked array of a plurality of substrates S from or to the outside The gate is closed by a gate valve (not shown) during an ALD process in order to keep the chamber 10 in a vacuum state.

The substrate support member 20 is disposed in the chamber 10, and is structured such that the plurality of the substrates S are stacked one onto another with a predetermined pitch. The substrate support member 20 may be a removable cassette for carrying the substrates S into the chamber 10 or an element fixedly received in the chamber 10.

Vertically adjacent ones of the substrates S received in the substrate support member 20 should be maintained at the same pitch to guarantee process accuracy. The pitch between vertically adjacent ones of the substrates S should be equal to the pitch between vertically adjacent ones of gas spray layers of the gas spray device 40 as will be described later.

The substrate support member 20 may further include a substrate rotation device (not shown) for separately and independently rotating the substrates S. The substrate rotation device is responsible for forming uniform films on the substrates S by rotating the substrates S at a predetermined speed during an ALD process. Of course, the substrate rotation device may not be included.

The substrate support member 20 may further include a heating device (not shown) for heating the substrates S. Taking into consideration that a temperature is a very critical factor for an ALD process, the use of the heating device during the ALD process may be effective for accurate adjustment of a substrate temperature. Of course, the temperature of the substrates S may be indirectly adjusted by adjusting the internal temperature of the chamber 10.

The substrate support member 20 may include a plurality of buffer layers 20a having no substrate thereon, which are disposed at top and bottom sides of the substrate support member 20. Since the buffer layers 20a serve to prevent the contamination of the chamber 10 that may be caused by a reactive gas or the like, they have no substrate thereon. That is, if the substrate support member 20 has no buffer layer, when the substrate support member 20 is moved to its uppermost or lowermost position during an ALD process, a space between the gas spray device 40 and the gas discharge device 50 is opened, and thus, there may arise problems such as the mixing of reactive gases or the diffusion of the reactive gases into other spaces of the chamber 10.

The batch-type ALD apparatus 1 includes the substrate movement device 30, as described above and the substrate movement device 30 is responsible for moving the substrate support member 20 upward or downward. The substrate movement device 30 may continuously move the substrate support member 20 in an upward or downward direction. Here, a single up-down movement of the substrate support member 20 constitutes two cycles of ALD.

The substrate movement device 30 may also move the substrate support member 20 periodically, i.e., in such a way that the substrate support member 20 is moved by a pitch between vertically adjacent ones of the substrates S and then stopped for a predetermined time. In detail, the phrase "periodic movement of the substrate support member 20" as used herein refers to repeated moving and stopping of the substrate support member 20 at predetermined time intervals, instead of continuous up-down movement of the substrate support member 20 at a predetermined speed. Here, the time for which the substrate support member 20 is stopped at a predetermined position may be variously changed considering optimal process conditions.

During such a periodic up-down movement of the substrate support member 20, each of the substrates S received in the substrate support member 20 passes sequentially through a first reactive gas zone, a purge gas zone, a second reactive gas zone, and others, to thereby complete each separate and independent ALD for all the substrates S. As such, the ALD apparatus 1 can perform ALD processing collectively for all the substrates S due to the substrate movement device 30.

In more detail, the substrate movement device 30 moves the substrate support member 20 repeatedly in such a way that the substrate support member 20 is moved by a pitch between vertically adjacent ones of the substrates S and then stopped for a predetermined time. An ALD process is performed during the stop time of the substrate support member 20.

A conventional ALD apparatus is structured such that a reactive gas supply source supplies reactive gases to substrates for a predetermined time and then a purge gas supply source supplies a purge gas to the substrates in a state wherein the reactive gas supply source, the purge gas supply source, and the substrates are fixedly positioned On the other hand, according to the ALD apparatus 1 of the current embodiment of the present invention, an ALD process is performed in such a way that a substrate is stayed for a predetermined time in a reactive gas zone defined by continuous supply of a reactive gas, and is then moved into a purge gas zone defined by continuous supply of a purge gas.

The gas spray device 40 is disposed at an internal side of the chamber 10 to continuously spray a gas in a direction parallel to the extending direction of each of the substrates S received in the substrate support member 20.

The gas spray device 40 may include one or more gas spray blocks and each gas spray block may include a plurality of gas spray layers operated independently with respect to each other. Here, the gas spray layers can each independently spray a different gas, and optionally adjust the spray pressure of the gas. Each gas spray layer may include one or more gas spray nozzles and spray a different gas through the nozzles. A gas spray direction may be parallel to the extending direction of each of the substrates S, and a gas spray pressure may be adjusted to a sufficient level to keep the direction of a gas flow constant without changing.

The gas spray device 40 is connected to a gas supply source 70 installed outside the chamber 10, as shown in FIG. 1. For example, the gas supply source 70 may include a purge gas supply source 70a, a first reactive gas supply source 70b, a second reactive gas supply source 70c, etc. The gas supply source 70 is connected to the gas spray device 40 via the wall of the chamber 10.

In detail, referring to FIG. 2, together with FIG. 1, each gas spray block according to an embodiment of the present invention may have a sequential vertical array of a first purge gas spray layer 40a, a first reactive gas spray layer 40b, a second purge gas spray layer 40c, a second reactive gas spray layer 40d, and a third purge gas spray layer 40e. That is, the second purge gas spray layer 40c may be interposed between the first and second reactive gas spray layers 40b and 40d, and the first and third purge gas spray layers 40a and 40e may be respectively disposed below the first reactive gas spray layer 40b and above the second reactive gas spray layer 40d to form gas curtains for preventing the deviation of first and second reactive gases from gas flow paths. By doing so, reactive gas zones are isolated from each other by a purge gas zone, and thus, reactive gases can be efficiently used for an ALD process without their leakage or diffusion into other spaces, and used reactive gases can be completely evacuated by the gas discharge device 50.

The first, second and third purge gas spray layers 40a, 40c and 40e may each be multi-layered, i.e., two or more layered, as shown in FIG. 2, in order to more efficiently block an interlayer mixing of reactive gases. Here, two purge gas spray layers and a reactive gas spray layer interposed therebetween may be defined as a gas spray unit considering that a reactive gas sprayed from the reactive gas spray layer is prevented from diffusion toward the outside and forms an isolated reactive gas zone.

The gas spray device 40 may also include three or more reactive gas spray layers depending on process conditions. Of course, in this case, it is preferable to dispose a purge gas spray layer above and below each reactive gas spray layer.

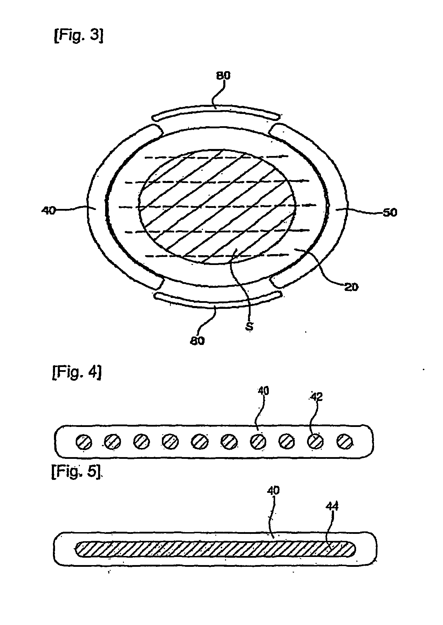

The gas spray device 40 may have a convexly curved cross-sectional shape at least partially surrounding the substrate support member 20, as viewed from top as in FIG. 3. Further, the gas spray device 40 may include a serial array of a plurality of spray nozzles 42, as shown in FIG. 4, or an elongated bar-shaped nozzle 44, as shown in FIG. 5.

The gas discharge device 50 is disposed in an opposite side of the chamber 10 to the gas spray device 40, and is responsible for sucking and evacuating the gases sprayed from the gas spray device 40.

The gas discharge device 50 may include a single outlet disposed to correspond to all the gas spray layers of the gas spray device 40. Alternatively, the gas discharge device 50 may also include one or more outlet layers, disposed to correspond to one or more gas spray blocks, being operated independently with respect to each other. Still alternatively, the gas discharge device 50 may also include a plurality of outlet layers, disposed to correspond to a plurality of gas spray units that each consists of a purge gas spray layer, a reactive gas spray layer, and a purge gas spray layer, being operated independently with respect to each other. Still alternatively, the gas discharge device 50 may also include a plurality of outlet layers, disposed to correspond to a plurality of gas spray layers, being operated independently with respect to each other.

For example, if the gas spray device 40 includes six gas spray layers, the gas discharge device 50 may also include six outlet layers. Further, the gas discharge device 50 should have a pressure sufficient to suck and evacuate all the gases sprayed from the gas spray device 40.

The gas discharge device 50 may have a convexly curved cross-sectional shape at least partially surrounding the substrate support member 20, as viewed from top as in FIG. 3.

Multi-layered, distinct gas zones are defined by the above-described gas spray device 40 and gas discharge device 50. For example, a purge gas zone, a first reactive gas zone, a purge gas zone, a second reactive gas zone, and a purge gas zone may be defined sequentially from bottom to top. As such, according to the batch-type ALD apparatus 1 of the current embodiment of the present invention, continuous gas supply is performed in distinct gas zones, and an ALD process may be performed by periodically moving the substrates S toward the gas zones. That is, unlike a conventional ALD process that is performed through periodic supply of reactive gases in a state wherein reactive gas supply sources and substrates are fixedly positioned, in the current embodiment of the present invention, reactive gases are continuously supplied to reactive gas zones, and an ALD process is performed by allowing the substrates S to pass through the reactive gas zones.

The gas spray device 40 and the gas discharge device 50 may be contacted as close as possible to the substrate support member 20. Of course, considering the up-down movement of the substrate support member 20, the gas spray device 40 and the gas discharge device 50 should be spaced apart from the substrate support member 20 by such a distance as not to disturb the up-down movement of the substrate support member 20. That is, it is preferable to contact the gas spray device 40 and the gas discharge device 50 as close as possible to the substrate support member 20, as shown in FIG. 2, in order to prevent the migration of a gas sprayed from the gas spray device 40 into other gas zones.

The batch-type ALD apparatus 1 may further include a blocking plate 80 interposed between a lateral side of the gas spray device 40 and the opposite lateral side of the gas discharge device 50 to surround the substrate support member 20 together with the gas spray device 40 and the gas discharge device 50. If a lateral side of the gas spray device 40 and the opposite lateral side of the gas discharge device 50 are spaced apart from each other, gases may diffuse toward other spaces of the chamber 10 via a space defined between the lateral sides. The diffused gases may adversely affect the substrates S before, during, or after an ALD process. In order to overcome this problem, it is important to maximally prevent the diffusion of gases. In this regard, the blocking plate 80 may be interposed between a lateral side of the gas spray device 40 and the opposite lateral side of the gas discharge device 50 to prevent gas diffusion, as shown in FIG. 3. Of course, the blocking plate 80 should be removably installed between a lateral side of the gas spray device 40 and the opposite lateral side of the gas discharge device 50 in order not to disturb the entrance or exit of the substrates S or the substrate support member 20 into or from the chamber 10.

The batch-type ALD apparatus 1 may further include a protection cover 90 disposed at top sides of the gas spray device 40 and the gas discharge device 50 and insertedly mounted to the substrate support member 20 to protect the substrates S, as shown in FIG. 1. In the current embodiment of the present invention, an ALD process is performed by moving the substrate support member 20 upward or downward, and thus, a substrate elevated above the position of the gas spray device 40 is exposed to an open space. No gases basically exist in the open space, but some reactive gases or other particles may be present. The protection cover 90 is responsible for preventing the adverse effect of such gases or particles on the substrates S.

The batch-type ALD apparatus may further include an auxiliary gas discharge device disposed at the chamber 10 to suck and evacuate gases in the chamber 10

The above embodiments have been explained in terms that an ALD process is performed through up-down movement of the substrate support member 20. However, an ALD process may also be performed by moving the gas spray device 40 and the gas discharge device 50 upward or downward with respect to the substrate support member 20 positioned at a fixed position. The latter case is advantageous to reduce the volume of the chamber 10.

Hereinafter, a method of operating the batch-type ALD apparatus 1 will be described exemplarily with reference to FIGS. 1 through 3.

A process of forming a ZrO₂ layer on a substrate will now be described exemplarily. In order to deposit a ZrO₂ layer using an ALD process, a Zr gas, an O₃ gas, and a N₂ purge gas are first prepared. In detail, a Zr gas is used as a first reactive gas source, an O₃ gas as a second reactive gas source, and a N₂ gas as a purge gas source.

Thus, a N₂ gas is sprayed from first, second, and third purge gas spray layers 40a, 40c and 40e connected to a N₂ supply source, a Zr gas is sprayed from a first reactive gas spray layer 40b, and an O₃ gas is sprayed from a second reactive gas spray layer 40d.

In this state, a substrate support member 20 having therein a vertically stacked array of a plurality of substrates S is moved upward by a substrate movement device 30 until all the substrates pass through all gas zones filled with gases sprayed from the gas spray layers. In detail, the uppermost substrate passes sequentially through gas zones filled with gases sprayed from the first purge gas spray layer 40a, the first reactive gas spray layer 40b, the second purge gas spray layer 40c, the second reactive gas spray layer 40d, and the third purge gas spray layer 40e. This completes one cycle of ALD.

In this manner, the subsequent substrates are sequentially subjected to an ALD process. When an ALD process for the lowermost substrate is completed, gas spraying is stopped and the substrate support member 20 is moved downward to repeat the above-described ALD process.

Alternatively, an ALD process may also be repeated through continuous up-down movement of the substrate support member 20 without stopping gas spraying.

As is apparent from the above description, the inventive batch-type ALD apparatus can perform ALD processing collectively for a plurality of substrates, thus ensuring an improved throughput.

Moreover, each separate and uniform ALD processing is performed for a plurality of substrates, thus ensuring improved deposition efficiency and film quality.

## Claims

1. A batch-type Atomic Layer Deposition (ALD) apparatus (1) comprising:
a chamber (10) that can be kept in a vacuum state;
a substrate support member (20), disposed in the chamber (10), adapted to suppor a plurality of substrates (S) to be stacked one onto another with a predetermined pitch;
a substrate movement device (30) adapted to move the substrate support member (20) upward or downward;
a gas spray device (40) adapted to continuously spray a gas in a direction parallel to the extending direction of each of the substrates (S) stacked in the substrate support member (20); and
a gas discharge device (50), disposed in an opposite side of the chamber (10) to the gas spray device (40), adapted to suck and evacuate the gas sprayed from the gas spray device (40),
**characterized in that** the gas spray device (40) comprises one or more gas spray blocks, each of which includes a plurality of gas spray layers operated independently with respect to each other, wherein each gas spray block has a sequential vertical array of a first purge gas spray layer (40a), a first reactive gas spray layer (40b), a second purge gas spray layer (40c), a second reactive gas spray layer (40d), and a third purge gas spray layer (40e).

2. The batch-type ALD apparatus (1) of claim 1, wherein the substrate movement device (30) is adapted to move the substrate support member (20) periodically in such a way that the substrate support member (20) is moved by a pitch between vertically adjacent ones of the substrates (S) and then stopped for a predetermined time.

3. The batch-type ALD apparatus (1) of claim 1 or 2, wherein each of the first (40a), second (40c), and third (40e) purge gas spray layers is multi-layered.

4. The batch-type ALD apparatus (1) of claim 1 or 2, wherein the gas spray device (40) has a convexly curved cross-sectional shape at least partially surrounding the substrate support member (20).

5. The batch-type ALD apparatus (1) of claim 1 or 2, wherein the gas discharge device (50) has a convexly curved cross-sectional shape at least partially surrounding the substrate support member (20).

6. The batch-type ALD apparatus (1) of claim 5, wherein the gas discharge device (50) comprises a single outlet disposed to correspond to all the gas spray layers of the gas spray device (40).

7. The batch-type ALD apparatus (1) of claim 5, wherein the gas discharge device (50) comprises one or more outlet layers, disposed to correspond to the one or more gas spray blocks, being operated independently with respect to each other.

8. The batch-type ALD apparatus (1) of claim 5, wherein the gas discharge device (50) comprises a plurality of outlet layers, disposed to correspond to a plurality of gas spray units that each consists of a purge gas spray layer, a reactive gas spray layer, and a purge gas spray layer, being operated independently with respect to each other.

9. The batch-type ALD apparatus (1) of claim 5, wherein the gas discharge device (50) comprises a plurality of outlet layers, disposed to correspond to the plurality of the gas spray layers, being operated independently with respect to each other.

10. The batch-type ALD apparatus (1) of claim 1, wherein the substrate support member (20) comprises a heating device adapted to heat the substrates.

11. The batch-type ALD apparatus (1) of claim 1, wherein the substrate support member (20) comprises a plurality of buffer layers (20a) having no substrate thereon, which are disposed at top and bottom sides of the substrate support member (20).

12. The batch-type ALD apparatus (1) of claim 1, wherein the substrate support member (20) comprises a substrate rotation device adapted to rotate the substrates (S) disposed thereon.

13. The batch-type ALD apparatus (1) of claim 1, further comprising a blocking plate (80) interposed between a lateral side of the gas spray device (40) and the opposite lateral side of the gas discharge device (50) to surround the substrate support member (20) together with the gas spray device (40) and the gas discharge device (50).

14. The batch-type ALD apparatus (1) of claim 1, further comprising a protection cover (90) disposed at top sides of the gas spray device (40) and the gas discharge device (50) and insertedly mounted to the substrate support member (20) to protect the substrates (S).

15. The batch-type ALD apparatus (1) of claim 1, further comprising an auxiliary gas discharge device disposed at the chamber (10) to suck and evacuate gases in the chamber (10).

## Patentansprüche

1. Diskontinuierliche Vorrichtung (1) zur Atomlagenabscheidung (ALD), umfassend:
eine Kammer (10), die in einem Vakuumzustand gehalten werden kann,
ein Substratträgerelement (20), das in der Kammer (10) angeordnet ist und ausgelegt ist, eine Vielzahl von Substraten (S) zu tragen, die mit einem festgelegten Abstand aufeinandergestapelt werden sollen,
eine Substratbewegungsvorrichtung (30), die ausgelegt ist, das Substratträgerelement (20) nach oben oder unten zu bewegen,
eine Gassprühvorrichtung (40), die ausgelegt ist, kontinuierlich ein Gas in eine Richtung parallel zur Verlaufsrichtung jedes der Substrate (S), die in dem Substratträgerelement (20) gestapelt sind, zu sprühen, und
eine Gasabzugsvorrichtung (50), die an einer der Gassprühvorrichtung (40) gegenüberliegenden Seite der Kammer (10) angeordnet ist und ausgelegt ist, das Gas, das aus der Gassprühvorrichtung (40) gesprüht wird, anzusaugen und abzuführen,
**dadurch gekennzeichnet, dass** die Gassprühvorrichtung (40) einen oder mehrere Gassprühblöcke umfasst, von denen jeder eine Vielzahl von Gassprühschichten aufweist, die unabhängig voneinander gesteuert werden, wobei jeder Gassprühblock eine aufeinanderfolgende senkrechte Anordnung aus einer ersten Spülgassprühschicht (40a), einer ersten Reaktivgassprühschicht (40b), einer zweiten Spülgassprühschicht (40c), einer zweiten Reaktivgassprühschicht (40d) und einer dritten Spülgassprühschicht (40e) aufweist.

2. Diskontinuierliche ALD-Vorrichtung (1) nach Anspruch 1, wobei die Substratbewegungsvorrichtung (30) ausgelegt ist, das Substratträgerelement (20) in regelmäßigen Abständen so zu bewegen, dass das Substratträgerelement (20) um einen Abstand zwischen senkrecht benachbarten Substraten (S) bewegt und anschließend eine festgelegte Zeit lang angehalten wird.

3. Diskontinuierliche ALD-Vorrichtung (1) nach Anspruch 1 oder 2, wobei jede von der ersten (40a), zweiten (40b) und dritten (40e) Spülgassprühschicht mehrschichtig ist.

4. Diskontinuierliche ALD-Vorrichtung (1) nach Anspruch 1 oder 2, wobei die Gassprühvorrichtung (40) eine konvex gekrümmte Querschnittsform aufweist, die zumindest teilweise das Substratträgerelement (20) umgibt.

5. Diskontinuierliche ALD-Vorrichtung (1) nach Anspruch 1 oder 2, wobei die Gasabzugsvorrichtung (50) eine konvex gekrümmte Querschnittsform aufweist, die zumindest teilweise das Substratträgerelement (20) umgibt.

6. Diskontinuierliche ALD-Vorrichtung (1) nach Anspruch 5, wobei die Gasabzugsvorrichtung (50) einen einzigen Auslass umfasst, der angeordnet ist, zu allen Gassprühschichten der Gassprühvorrichtung (40) zu passen.

7. Diskontinuierliche ALD-Vorrichtung (1) nach Anspruch 5, wobei die Gasabzugsvorrichtung (50) eine oder mehrere Auslassschichten umfasst, die angeordnet sind, dem einen oder den mehreren Gassprühblöcken zu entsprechen, und unabhängig voneinander gesteuert werden.

8. Diskontinuierliche ALD-Vorrichtung (1) nach Anspruch 5, wobei die Gasabzugsvorrichtung (50) eine Vielzahl von Auslassschichten umfasst, die angeordnet sind, einer Vielzahl von Gassprüheinheiten zu entsprechen, die jeweils aus einer Spülgassprühschicht, einer Reaktivgassprühschicht und einer Spülgassprühschicht bestehen, und unabhängig voneinander gesteuert werden.

9. Diskontinuierliche ALD-Vorrichtung (1) nach Anspruch 5, wobei die Gasabzugsvorrichtung (50) eine Vielzahl von Auslassschichten umfasst, die angeordnet sind, der Vielzahl der Gassprühschichten zu entsprechen, und unabhängig voneinander betrieben werden.

10. Diskontinuierliche ALD-Vorrichtung (1) nach Anspruch 1, wobei das Substratträgerelement (20) eine Heizvorrichtung umfasst, die ausgelegt ist, die Substrate zu erwärmen.

11. Diskontinuierliche ALD-Vorrichtung (1) nach Anspruch 1, wobei das Substratträgerelement (20) eine Vielzahl von Pufferschichten (20a) umfasst, auf denen sich kein Substrat befindet und die auf der Ober- und Unterseite des Substratträgerelements (20) angeordnet sind.

12. Diskontinuierliche ALD-Vorrichtung (1) nach Anspruch 1, wobei das Substratträgerelement (20) eine Substratdrehvorrichtung umfasst, die ausgelegt ist, die darauf angeordneten Substrate (S) zu drehen.

13. Diskontinuierliche ALD-Vorrichtung (1) nach Anspruch 1, ferner umfassend eine Sperrplatte (80), die zwischen einer seitlichen Seite der Gassprühvorrichtung (40) und der gegenüberliegenden seitlichen Seite der Gasabzugsvorrichtung (50) angeordnet ist, um das Substratträgerelement (20) zusammen mit der Gassprühvorrichtung (40) und der Gasabzugsvorrichtung (50) zu umgeben.

14. Diskontinuierliche ALD-Vorrichtung (1) nach Anspruch 1, ferner umfassend eine Schutzabdeckung (90), die an der Oberseite der Gassprühvorrichtung (40) und der Gasabzugsvorrichtung (50) angeordnet ist und eingeschoben an dem Substratträgerelement (20) montiert ist, um die Substrate (S) zu schützen.

15. Diskontinuierliche ALD-Vorrichtung (1) nach Anspruch 1, ferner umfassend eine zusätzliche Gasabzugsvorrichtung, die an der Kammer (10) angeordnet ist, um Gase in der Kammer (10) anzusaugen und abzuführen.

## Revendications

1. Appareil (1) de dépôt de couche atomique (ALD) de type par lots, comprenant :
- une chambre (10) qui peut être maintenue dans un état de vide ;
- un élément (20) de support de substrats, disposé dans la chambre (10), apte à supporter une pluralité de substrats (S) devant être empilés les uns sur les autres avec un pas prédéterminé ;
- un dispositif (30) de déplacement de substrats apte à déplacer l'élément (20) de support de substrats vers le haut ou vers le bas ;
- un dispositif (40) de pulvérisation de gaz, apte à pulvériser en continu un gaz dans une direction parallèle à la direction d'extension de chacun des substrats (S) empilés dans l'élément (20) de support de substrats ; et
- un dispositif (50) de décharge de gaz, disposé dans un côté opposé de la chambre (10) au dispositif (40) de pulvérisation de gaz, apte à aspirer et évacuer le gaz pulvérisé par le dispositif (40) de pulvérisation de gaz,
**caractérisé par le fait que** le dispositif (40) de pulvérisation de gaz comprend un ou plusieurs blocs de pulvérisation de gaz, dont chacun comprend une pluralité de couches de pulvérisation de gaz actionnées de façon indépendante les unes par rapport aux autres, chaque bloc de pulvérisation de gaz ayant un arrangement vertical séquentiel d'une première couche de pulvérisation de gaz de purge (40a), une première couche de pulvérisation de gaz réactif (40b), une seconde couche de pulvérisation de gaz de purge (40c), une seconde couche de pulvérisation de gaz réactif (40d) et une troisième couche de pulvérisation de gaz de purge (40e).

2. Appareil ALD (1) de type par lots selon la revendication 1, dans lequel le dispositif (30) de déplacement de substrats est apte à déplacer l'élément (20) de support de substrats de façon périodique d'une manière telle que l'élément (20) de support de substrats est déplacé d'un pas entre ceux adjacents verticalement des substrats (S), puis stoppé pendant une durée prédéterminée.

3. Appareil ALD (1) de type par lots selon l'une des revendications 1 ou 2, dans lequel chacune des première (40a), deuxième (40c) et troisième (40e) couches de pulvérisation de gaz de purge est multicouches.

4. Appareil ALD (1) de type par lots selon l'une des revendications 1 ou 2, dans lequel le dispositif (40) de pulvérisation de gaz a une forme en coupe transversale incurvée de façon convexe, entourant au moins partiellement l'élément (20) de support de substrats.

5. Appareil ALD (1) de type par lots selon l'une des revendications 1 ou 2, dans lequel le dispositif (50) de décharge de gaz a une forme en coupe transversale incurvée de façon convexe entourant au moins partiellement l'élément (20) de support de substrats.

6. Appareil ALD (1) de type par lots selon la revendication 5, dans lequel le dispositif (50) de décharge de gaz comprend une simple sortie disposée pour correspondre à la totalité des couches de pulvérisation de gaz du dispositif (40) de pulvérisation de gaz.

7. Appareil ALD (1) de type par lots selon la revendication 5, dans lequel le dispositif (50) de décharge de gaz comprend une ou plusieurs couches de sortie, disposées pour correspondre au ou aux blocs de pulvérisation de gaz, étant actionnées de manière indépendante les unes par rapport aux autres.

8. Appareil ALD (1) de type par lots selon la revendication 5, dans lequel le dispositif (50) de décharge de gaz comprend une pluralité de couches de sortie, disposées pour correspondre à une pluralité d'unités de pulvérisation de gaz qui consistent chacune en une couche de pulvérisation de gaz de purge, une couche de pulvérisation de gaz réactif et une couche de pulvérisation de gaz de purge, étant actionnées de façon indépendante les unes par rapport aux autres.

9. Appareil ALD (1) de type par lots selon la revendication 5, dans lequel le dispositif (50) de décharge de gaz comprend une pluralité de couches de sortie, disposées pour correspondre à la pluralité de couches de pulvérisation de gaz, étant actionnées de manière indépendante les unes par rapport aux autres.

10. Appareil ALD (1) de type par lots selon la revendication 1, dans lequel l'élément (20) de support de substrats comprend un dispositif de chauffage apte à chauffer les substrats.

11. Appareil ALD (1) de type par lots selon la revendication 1, dans lequel l'élément (20) de support de substrats comprend une pluralité de couches tampons (20a) n'ayant pas de substrat sur celles-ci, qui sont disposées sur les côtés supérieur et inférieur de l'élément (20) de support de substrats.

12. Appareil ALD (1) de type par lots selon la revendication 1, dans lequel l'élément (20) de support de substrats comprend un dispositif de rotation de substrats apte à faire tourner les substrats (S) disposés sur celui-ci.

13. Appareil ALD (1) de type par lots selon la revendication 1, comprenant en outre une plaque de blocage (80) interposée entre un côté latéral du dispositif (40) de pulvérisation de gaz et le côté latéral opposé du dispositif (50) de décharge de gaz pour entourer l'élément (20) de support de substrats Conjointement avec le dispositif (40) de pulvérisation de gaz et le dispositif (50) de décharge de gaz.

14. Appareil ALD (1) de type par lots selon la revendication 1, comprenant en outre un couvercle de protection (90) disposé sur les côtés supérieurs du dispositif (40) de pulvérisation de gaz et du dispositif (50) de décharge de gaz et monté de façon insérée sur l'élément (20) de support de substrats pour protéger les substrats (S).

15. Appareil ALD (1) de type par lots selon la revendication 1, comprenant en outre un dispositif de décharge de gaz auxiliaire disposé sur la chambre (10) pour aspirer et évacuer les gaz dans la chambre (10).
